# EUROPÄISCHE PATENTSCHRIFT

(11) **EP 2 313 538 B1**
(45) Veröffentlichungstag und Bekanntmachung des Hinweises auf die Patenterteilung: **05.03.2014**
(21) Anmeldenummer: 09776015.1
(22) Anmeldetag: 27.07.2009
(51) Int. Cl.: F27D 99/00, C23C 16/04, C23C 16/44

(54) **VORRICHTUNG ZUR PLASMAGESTÜTZTEN BESCHICHTUNG DER INNENSEITE VON ROHRFÖRMIGEN BAUTEILEN.**
DEVICE FOR PLASMA-ASSISTED COATING OF THE INNER SIDE OF TUBULAR COMPONENTS
DISPOSITIF POUR UNE APPLICATION DE REVÊTEMENT ASSISTÉE PAR PLASMA SUR LE CÔTÉ INTÉRIEUR DE PIÈCES TUBULAIRES

(30) Priorität: 25.07.2008 DE 102008035019; 26.07.2008 DE 102008034899
(43) Veröffentlichungstag der Anmeldung: 27.04.2011
(73) Patentinhaber: Dr. Laure Plasmatechnologie GmbH, 70329 Stuttgart (DE)
(72) Erfinder: LAURE, Stefan, 70329 Stuttgart (DE)
(74) Vertreter: Geitz Truckenmüller Lucht
(86) Internationale Anmeldenummer: PCT/DE2009/001041
(87) Internationale Veröffentlichungsnummer: WO 2010/009724

(56) Entgegenhaltungen:
- WO-A-99/04067
- DE-A1- 19 959 845
- US-A- 4 803 948

## Beschreibung

Es wird eine Vorrichtung zur plasmagestützten Beschichtung der Innenseite von rohrförmigen Bauteilen mittels eines hochfrequenten Magnetfeldes vorgeschlagen.

Vorrichtungen zur plasmagestützten Beschichtung der Innen- oder Außenseite eines rohrförmigen Bauteils sind aus der DE 199 59 845 A1 und der DE 103 53 540 A1 bekannt. Dabei wird das rohrförmige Bauteil oder ein das Bauteil umgebendes Schutzrohr an den geöffneten Enden durch Flansche verschlossen und das Innere des rohrförmigen Bauteils oder des Zwischenraums zwischen dem Bauteil und dem Schutzrohr evakuiert. Hierzu sind an mindestens einen der beiden Flansche eine oder mehrere Vakuumpumpen angeschlossen. Die Vorrichtung weist ferner einen Hochfrequenzschwingkreis auf. Dieser ist mit einer Spule ausgestattet, welche mit ihren Windungen das rohrförmige Bauteil umgibt. Die Windungen verlaufen koaxial zum Bauteil an seiner Außenseite. Durch das hochfrequente Magnetfeld der Spule wird in dem rohrförmigen Bauteil ein Plasma erzeugt. Ein in das rohrförmige Bauteil eingeleiteter Beschichtungsstoff wird durch eine plasma-unterstützte chemische Reaktion umgesetzt. Das Reaktionsprodukt scheidet sich als Beschichtung an dem rohrförmigen Bauteil ab. Durch Verschieben der Spule relativ zu dem rohrförmigen Bauteil oder durch Verschieben des Bauteils relativ zu der Spule wird eine Beschichtung über die gesamte Länge des Bauteils erzielt.

Die zu beschichtenden rohrförmigen Bauteile weisen häufig Unebenheiten an ihren Oberflächen und Abweichungen bezüglich ihres Querschnitts senkrecht zu ihrer Längsachse. Dies gilt insbesondere bei Bauteilen aus Glas. Selbst wenn diese Ungenauigkeiten im Bereich der für die rohrförmigen Bauteile vorgegebenen Fertigungstoleranzen liegen, ist ein Einbau derartiger rohrförmiger Bauteile in die bekannten Vorrichtungen erschwert oder unmöglich. Die Flansche der bekannten Vorrichtungen weisen eine an den Querschnitt der Bauteile angepasste Aufnahme und eine an der Aufnahme angeordnete Dichtung auf. Eine Ungenauigkeit des rohrförmigen Bauteils kann dazu führen, dass dieses nicht in die Aufnahme der Flansche passt. Darüber hinaus kann eine Ungenauigkeit des rohrförmigen Bauteils zur Folge haben, dass es zwar in die Aufnahmen eingeführt werden kann aber dabei keine ausreichende Dichtwirkung durch die Dichtungen erzielt wird. In letzten Fall wird selbst bei hoher Pumpleistung kein für die Beschichtung notwendiger Enddruck in dem rohrförmigen Bauteil erreicht. Der im Inneren des rohrförmigen Bauteils herrschende Druck wirkt sich massiv auf die Qualität der durch das Plasma abgeschiedenen Beschichtung aus. Das Erreichen eines für die Beschichtung vorgegebenen Enddrucks ist daher für die Qualität der Beschichtung von entscheidender Bedeutung.

Aus der WO 99/04067 A ist eine aufblasbare elastomere Dichtung für schnelle thermische Behandlunqen (RTP) bekannt, um trotz unterschiedlicher Ausdehnungskoeffizienten der verschiedenen Teile einer Behandlungskammer die Reinheit innerhalb der Behandlungskammer zu garantieren. Jedoch sorgen diese Dichtungen nicht dafür, dass Ungenauigkeiten, Umregelmäßigkeiten oder Unebenheiten der Oberflächen kompensiert werden, an denen die Dichtungen anliegen.

Der Erfindung liegt die Aufgabe zugrunde, eine Vorrichtung zur plasmagestützten Beschichtung der Innenseite von rohrförmigen Bauteilen mittels eines hochfrequenten Magnetfeldes zu Verfügung zu stellen, die auch bei mit Ungenauigkeiten hinsichtlich der Form behafteten Bauteilen die Aufnahme, das Halten, Positionieren und Evakuieren auf einen vorgegebenen Enddruck ermöglicht.

Diese Aufgabe wird durch eine Vorrichtung mit den Merkmalen des Anspruchs 1 gelöst. Die Vorrichtung zeichnet sich dadurch aus, dass sie mit mindestens zwei Aufnahmekörpern ausgestattet ist, welche ein rohrförmiges Bauteil an dessen Enden aufnehmen, halten und das Innere des rohrförmigen Bauteils gegen die Umgebung abdichten. An dem Aufnahmekörper ist mindestens eine aufblasbare Dichtung angeordnet, welche im aufgeblasenen Zustand eine Abdichtung des Übergangs zwischen dem Aufnahmekörper und dem rohrförmigen Bauteil gegen die Umgebung ausbildet. Dabei legt sich die aufgeblasene oder aufgeblähte Dichtung um die Außenseite und/ oder die Stirnseite des rohrförmigen Bauteils und dichtet einen Zwischenraum zwischen dem rohrförmigen Bauteil und dem Aufnahmekörper ab. Sie bildet im aufgeblasenen Zustand eine Barriere gegen einen ungewollten Stoffübergang zwischen dem Inneren des rohrförmigen Bauteils und der Umgebung. Beim Ausdehnen passt sich die Dichtung eventuellen Ungenauigkeiten, Unregelmäßigkeiten oder Unebenheiten des rohrförmigen Bauteils an und füllt den Zwischenraum zwischen dem Aufnahmekörper und dem Bauteil aus. Im nicht ausdehnten Zustand ist der Querschnitt der Dichtung reduziert. Sie gibt in diesem Zustand einen Zwischenraum zwischen ihr und dem Aufnahmekörper frei, so dass ein rohrförmiges Bauteil einfach, schnell und ohne Beschädigungen in die Vorrichtung ein- und ausgebaut werden kann.

Die beiden Aufnahmekörper werden beim Einbau an die Enden des rohrförmigen Bauteils herangeführt und auf die Enden aufgesetzt. Jeder der beiden Aufnahmekörper weist einen Auflagebereich auf, welcher eine Auflage für ein Ende des rohrförmigen Bauteils bildet. Dabei kann es sich beispielsweise um einen rohrförmigen Abschnitt des Aufnahmeelements handeln, an den sich das rohrförmige Bauteil von außen mit seiner Innenseite anlegt. Über die Auflage nehmen die beiden Aufnahmekörper die Gewichtskraft des rohrförmigen Bauteils auf und halten das Bauteil in seiner Position. Beim Abdichten drückt die aufblasbare Dichtung aufgrund ihrer starken räumlichen Ausdehnung das rohrförmige Bauteil an den Aufnahmekörper und sorgt neben der Abdichtung für eine Stabilisierung des Bauteils in seiner Position an den Aufnahmekörpern. Die Kombination aus den Aufnahmekörpern und der aufblasbaren Dichtung führt damit nicht nur zu einer besseren Abdichtung sondern auch zu einer stabileren Halterung des rohrförmigen Bauteils.

Die aufblasbare Dichtung weist mindestens einen Hohlraum auf. Dieser Hohlraum ist an eine Zufuhr und Ableitung eines Mediums angeschlossenen. Bei Einströmen des Mediums in den Hohlraum dehnt sich die aufblasbare Dichtung aus. Bei Ausströmen des Mediums aus dem Hohlraum zieht sich die aufblasbare Dichtung wieder zusammen.

Dank der gegenüber bekannten Vorrichtungen verbesserten Abdichtung des Übergangs zwischen dem rohrförmigen Bauteil und den Aufnahmekörpern wird bei gleicher Pumpleistung einer an mindestens einen Aufnahmekörper angeschlossenen Vakuumpumpe ein deutlich geringerer Enddruck erreicht. Ferner wird ein vorgegebener Enddruck bei einer geringeren Pumpleistung erreicht als bei bekannten Vorrichtungen. Die Zeit, die nach dem Einbau eines rohrförmigen Bauteils in die Aufnahmekörper benötigt wird, bis sich ein vorgegebener Enddruck eingestellt hat, ist wesentlich kürzer als bei bekannten Vorrichtungen, was zu einer Verkürzung der Prozesszeit führt. Dank der zuverlässigen Einstellung eines vorgegebenen Enddrucks bei rohrförmigen Bauteilen mit Unregelmäßigkeiten innerhalb der Fertigungstoleranzen wird eine qualitativ hochwertige und reproduzierbare Beschichtung erreicht.

Um eine plasma-unterstützte Abscheidung der Beschichtung entlang des gesamten rohrförmigen Bauteils zu erhalten, werden die mit ihren Windungen des Bauteil umgebende Spule und das Bauteil relativ zueinander bewegt. Die Geschwindigkeit dieser Translationsbewegung ist steuerbar. Auf diese Weise kann der Schichtaufbau der Beschichtung beeinflusst werden.

Mit der Vorrichtung können rohrförmige Bauteile beschichtet werden, die an beiden Enden offen sind, Bauteile, die an einem Ende offen und am anderen Ende geschlossen sind, sowie Bauteile, die an beiden Ende geschlossen sind. Bei ein- und beidseitig geöffneten Bauteilen kann der Beschichtungsstoff über einen der Aufnahmekörper in das Innere des Bauteils eingeleitet werden. Bei beidseitig geschlossenen Bauteilen muss der Beschichtungsstoff vor dem Verschließen in das Bauteil eingebracht werden.

Nach einer vorteilhaften Ausgestaltung der Erfindung sind die Aufnahmekörper in entgegen gesetzte Richtungen verschiebbar angeordnet sind. Das Verschieben bewirkt eine Vergrößerung und Verkleinerung des Abstands zwischen den Aufnahmekörpern. Dies dient dem Ein- und Ausbau eines rohrförmigen Bauteils. Zum Einbau werden die Aufnahmekörper auseinander bewegt, so dass sich ein maximaler Abstand zwischen ihnen einstellt. Dann wird das Bauteil zwischen die Aufnahmekörper eingeführt und die Aufnahmekörper anschließend aufeinander zu bewegt, bis sie das rohrförmige Bauteil berühren. Zum Verschieben der Aufnahmekörper kann ein Antrieb vorgesehen sein. Der Vorgang kann automatisiert sein. Hierzu ist vorteilhafterweise ein Sensor vorgesehen, der die Berührung zwischen einem Aufnahmekörper und dem Bauteil erfasst. Sobald eine Berührung festgestellt wird, wird der Antrieb abgeschaltet. Sind beide Aufnahmekörper an dem Bauteil in Position gebracht, ist das Bauteil durch die Aufnahmekörper gehalten. Anschließend wird die aufblasbare Dichtung ausgedehnt um das Bauteil gegen die Umgebung abzudichten. Anschließend wird das Innere des rohrförmigen Bauteils durch die Vakuumpumpen auf einen vorgegebenen Enddruck evakuiert. Ist der vorgegebene Enddruck erreicht, wird das Plasma gezündet und der Beschichtungsstoff in das Innere des Bauteils eingeleitet um die Beschichtung auf aufzubringen. Nach Abschluss des Beschichtungsprozesses wird das Bauteil belüftet, die aufblasbare Dichtung wird wieder in ihren nicht ausgedehnten Ausgangszustand überführt, und die Aufnahmekörper werden von dem Bauteil entfernt. Anschließend kann das Bauteil aus der Vorrichtung herausgenommen werden. Die Vorrichtung ist bereit für den Einbau des nächsten Bauteils. Aufgrund des variablen Abstands zwischen den Aufnahmekörpern können rohrförmige Bauteile unterschiedlicher Länge zwischen die Aufnahmekörper eingesetzt und mit der Vorrichtung beschichtet werden.

Nach einer weiteren vorteilhaften Ausgestaltung der Erfindung ist die Vorrichtung zusätzlich zu den Aufnahmekörpern mit Stützeinrichtungen ausgestattet, welche eine Auflage für ein rohrförmiges Bauteil von unten bilden. Sie sorgen insbesondere bei langen Bauteilen für eine zusätzliche Stütze zwischen den Aufnahmekörpern. Darüber hinaus erleichtern sie den Einbau eines rohrförmigen Bauteils. Die Aufnahmekörper können so weit voneinander entfernt werden, dass sie das Bauteil beim Einbau nicht berühren. Das Bauteil wird auf die Stützeinrichtungen gelegt und die Aufnahmekörper werden auf das Bauteil zu bewegt, wodurch sich ihr Abstand verkleinert, bis sie das Bauteil aufnehmen. Der Ausbau des Bauteils erfolgt entsprechend. Das Bauteil muss damit nur noch vor der Beschichtung auf die Stützeinrichtungen gelegt und nach dem Abschluss der Beschichtung von den Stützeinrichtungen entfernt werden. Alle übrigen Schritte können automatisch ablaufen. Dies erleichtert den Beschichtungsprozess. An den Benutzer werden keine besonderen Anforderungen gestellt. Die Reproduzierbarkeit wird erhöht.

Nach einer weiteren vorteilhaften Ausgestaltung der Erfindung weisen die Stützeinrichtungen ein U-förmiges Halteelement auf. Dieses Halteelement öffnet sich nach oben. Sind mindestens zwei derartige Halteelemente an einem oder mehreren Stützeinrichtungen vorgesehen, so wird das Bauteil stabil gehalten.

Nach einer weiteren vorteilhaften Ausgestaltung der Erfindung sind die Stützeinrichtungen höhenverstellbar. Sie können damit an unterschiedliche Bauteile mit verschiedenen Durchmessern angepasst werden.

Nach einer weiteren vorteilhaften Ausgestaltung der Erfindung weist die aufblasbare Dichtung im ausgedehnten Zustand eine Ausdehnung in radialer Richtung bezogen auf die Längsachse der Aufnahmekörper auf. Sie drücken damit von außen gegen das rohrförmige Bauteil, welches von innen durch die Aufnahmekörper abgestützt und gehalten sein kann.

Nach einer weiteren vorteilhaften Ausgestaltung der Erfindung weisen die Aufnahmekörper je ein rohrförmiges Ansatzstück auf, welches eine Auflage für die Innenseite des rohrförmigen Bauteils an dessen Ende bildet. Das rohrförmige Ansatzstück und das Bauteil überlappen über einen Teil oder die gesamte Länge des Ansatzstücks. Diese Überlappung sorgt für eine Stabilisierung des Bauteils. Das rohrförmige Ansatzstück hat ferner den Vorteil, dass es die Einstellung eines vorgegebenen Enddrucks nicht beeinträchtigt, da es keine nach innen abstehenden Elemente aufweist, die die Strömung negativ beeinflussen können. Das rohrförmige Ansatzstück wirkt insbesondere gut mit einer sich radial nach innen ausdehnenden, aufblasbaren Dichtung zusammen. Die Dichtung drückt im ausgedehnten Zustand das Bauteil an das rohrförmige Ansatzstück.

Nach einer weiteren vorteilhaften Ausgestaltung der Erfindung begrenzt das rohrförmige Ansatzstück an seiner Innenseite einen zylindrischen Hohlraum. Die Wandstärke des rohrförmigen Ansatzstücks ist dabei an dem dem anderen Aufnahmekörper zugewandten Ende kleiner als an dem dem anderen Aufnahmekörper abgewandten Ende. Dies erleichtert das Aufsetzen des Bauteils auf den Aufnahmekörper oder umgekehrt, da der Außendurchmesser des rohrförmigen Ansatzstücks an der dem anderen Aufnahmekörper zugewandten Seite kleiner ist.

Nach einer weiteren vorteilhaften Ausgestaltung der Erfindung sind die Aufnahmekörper mit einem radial nach außen abstehenden Abschnitt ausgestattet. Dieser bildet einen Anschlag für die Stirnseite eines rohrförmigen Bauteils.

Nach einer weiteren vorteilhaften Ausgestaltung der Erfindung ist der radial nach außen abstehende Abschnitt mit einer Vertiefung ausgestattet. In dieser Vertiefung ist ein Pufferelement aus einem elastischen Material angeordnet. Das Pufferelement ist insbesondere elastischer als die Aufnahmekörper. Es verhindert eine Beschädigung eines rohrförmigen Bauteils auf die Aufnahmekörper.

Nach einer weiteren vorteilhaften Ausgestaltung der Erfindung ist der radial abstehenden Abschnitt mit einem Anschluss für die Zufuhr und das Ableiten eines Mediums zum Aufblähen der aufblasbaren Dichtung ausgestattet. Dabei kann es beispielsweise um Druckluft handeln.

Nach einer weiteren vorteilhaften Ausgestaltung der Erfindung ist die aufblasbare Dichtung durch einen Stützring an dem Aufnahmekörper gehalten. Der Stützring begrenzt zusammen mit dem Aufnahmekörper und gegebenenfalls dem Bauteil den für die Ausdehnung der elastischen Dichtung zur Verfügung stehenden Raum. Er verhindert ferner, dass sich die aufblasbare Dichtung von dem Aufnahmekörper lösen kann.

Nach einer weiteren vorteilhaften Ausgestaltung der Erfindung ist mindestens einer der Aufnahmekörper mit einem Anschluss an eine oder mehrere Pumpen ausgestattet. Über diese Pumpe wird der vorgegebene Enddruck in dem rohrförmigen Bauteil eingestellt.

Nach einer weiteren vorteilhaften Ausgestaltung der Erfindung ist mindestens einer der Aufnahmekörper mit einem Anschluss für die Zufuhr eines Beschichtungsstoffs und/ oder eines Arbeitsgases in das Innere eines an den Aufnahmekörpern angeordneten rohrförmigen Bauteils ausgestattet. Der Beschichtungsstoff kann fest, flüssig oder gasförmig sein. Zur Aufbereitung des Beschichtungsstoffs kann eine Precursor-Aufbereitungseinrichtung vorgesehen sein. Je nach Anforderungen kann das Arbeitsgas das Bauteil in axialer Richtung durchströmen oder tangential entlang der nach innen weisenden Oberfläche zugeführt werden. Bei einer tangentialen Geschwindigkeitskomponente bildet sich eine Wirbelströmung aus. Auf diese Weise kann der Schichtaufbau beeinflusst werden.

Nach einer weiteren vorteilhaften Ausgestaltung der Erfindung ist mindestens einer der Aufnahmekörper mit einer ausfahrbaren Lanze für die Zufuhr eines Beschichtungsstoffs in das Innere eines an den Aufnahmekörpern angeordneten rohrförmigen Bauteils ausgestattet. Diese Lanze unterstützt insbesondere bei einseitig geschlossenen rohrförmigen Bauteilen das Einleiten und Verteilen des Beschichtungsstoffs.

Weitere Vorteile und vorteilhafte Ausgestaltungen der Erfindung sind der nachfolgenden Beschreibung, der Zeichnung und den Ansprüche entnehmbar.

### Zeichnung

In der Zeichnung ist ein Ausführungsbeispiel der Erfindung dargestellt. Es zeigen:
- Figur 1: Vorrichtung zur plasmagestützten Beschichtung der Innenseite von rohrförmigen Bauteilen mittels eines hochfrequenten Magnetfeldes mit geschlossener Klappe in perspektivischer Ansicht,
- Figur 2: Vorrichtung gemäß Figur 1 mit geöffneter Klappe,
- Figur 3: Vorrichtung gemäß Figur 2 in einer Ansicht von vorne,
- Figur 4: Ausschnitt aus Figur 3 mit dem rohrförmigen Bauteil, den Aufnahmekörpern, den Stützeinrichtungen und der Spule,
- Figur 5: Aufnahmekörper der Vorrichtung gemäß Figur 1 im Längsschnitt ohne rohrförmiges Bauteil und mit aufblasbarer Dichtung im Ausgangszustand,
- Figur 6: Aufnahmekörper gemäß Figur 5 mit rohrförmigem Bauteil,
- Figur 7: Aufnahmekörper gemäß Figur 6 mit aufblasbarer Dichtung im ausgedehnten Zustand.

### Beschreibung des Ausführungsbeispiels

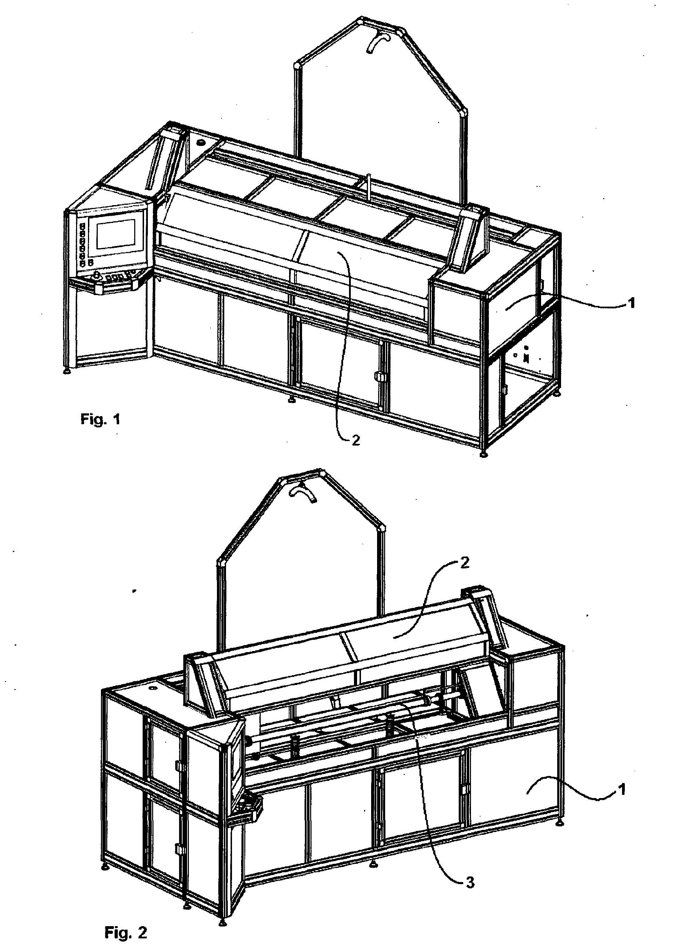

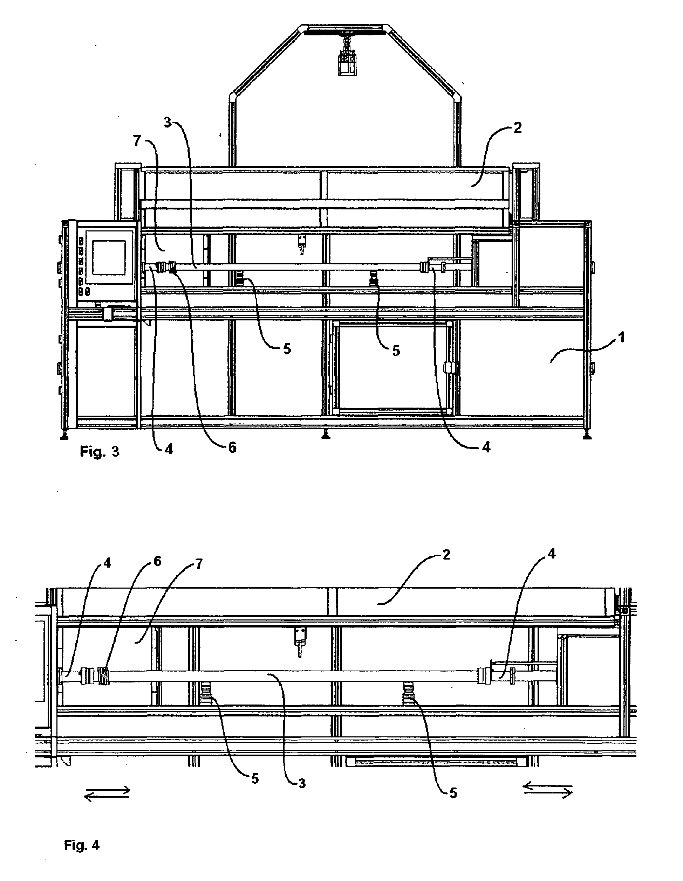

In den Figuren 1 bis 4 ist eine Vorrichtung zur plasmagestützten Beschichtung der Innenseite von rohrförmigen Bauteilen mittels eines hochfrequenten Magnetfeldes in verschiedenen Ansichten dargestellt. Figur 1 zeigt die Vorrichtung mit vollständig geschlossenem Gehäuse 1. In den Figuren 2, 3 und 4 ist eine Klappe 2 an dem Gehäuse 1 geöffnet, welche den Bereich abdeckt, in dem ein rohrförmiges Bauteil 3 zur Beschichtung angeordnet wird. Um das Bauteil 1 zu halten und gegen die Umgebung abzudichten, sind an der Vorrichtung Aufnahmekörper 4 vorgesehen. Diese halten das Bauteil an seinen beiden Enden. Die Aufnahmekörper 4 werden zum Ein- und Ausbau des rohrförmigen Bauteils in Richtung der in Figur 4 dargestellten Pfeile bewegt. Das Bauteil wird ferner durch die beiden Stützeinrichtungen 5 gehalten. Während die beiden Aufnahmekörper 4 das Bauteil 3 seitlich an seinen Enden halten, unterstützen die beiden Stützeinrichtungen 5 das Bauteil von unten. Das durch die Aufnahmekörper 4 und die Stützeinrichtungen 5 gehaltene Bauteil 3 ist in der Vorrichtung horizontal ausgerichtet. Im unteren Teil des Gehäuses 1 sind Vakuumpumpen, eine Steuereinrichtung und eine Aufbereitungseinrichtung für den Beschichtungsstoff oder einen Precursor angeordnet. Sie sind aufgrund des geschlossenen Gehäuses in der Zeichnung nicht erkennbar. Darüber hinaus ist ein Antrieb zum Verschieben der beiden Aufnahmekörper 4 in dem Gehäuse angeordnet. Dieser ist ebenfalls durch das geschlossene Gehäuse abgedeckt und daher in der Zeichnung nicht erkennbar.

Die Vorrichtung ist ferner mit einem Hochfrequenzschwingkreis ausgestattet, zu der eine Spule 6 gehört. Das rohrförmige Bauteil 3 verläuft in den Windungen der Spule 6. Eine die beiden Aufnahmekörper entlang ihrer Symmetrieachse miteinander verbindende Gerade fällt zusammen mit der Längsachse des rohrförmigen Bauteils 3 und mit der Längsachse der Windungen der Spule 6. Diese Gerade wird als Längsachse der Vorrichtung definiert. Sie ist in der Zeichnung nicht dargestellt. Die übrigen Komponenten des Schwingkreises sind in dem Gehäuseteil 7 angeordnet. Die Spule 6 ist fest mit dem Gehäuseteil 7 verbunden. Zum Beschichten der Innenseite des rohrförmigen Bauteils 3 wird die Spule 6 zusammen mit dem Gehäuseteil 7 parallel zum rohrförmigen Bauteil verschoben, so dass die Spule 6 in zeitlicher Abfolge das Bauteil über seine gesamte Länge abdeckt. In der Darstellung gemäß Figur 2, 3 und 4 befinden sich die Spule 6 und das Gehäuseteil 7 auf der rechten Seite.

Die Spule 6 kann zylindrisch oder konisch gewickelt sein. Sie kann ferner zumindest eine gegenläufige Wicklung aufweisen. Darüber hinaus kann die Spule an den Durchmesser des rohrförmigen Bauteils 3 angepasst werden. Durch die Auswahl und die Ausgestaltung der Spule 6 kann die Frequenz des Hochfrequenzschwingkreises, die Ausbildung des Plasmas und der Schichtaufbau beeinflusst werden.

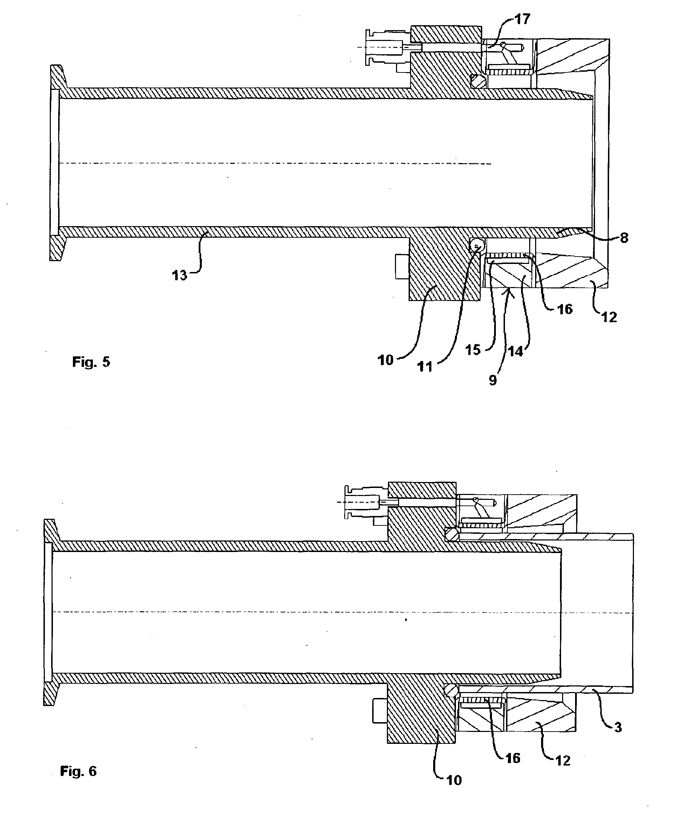

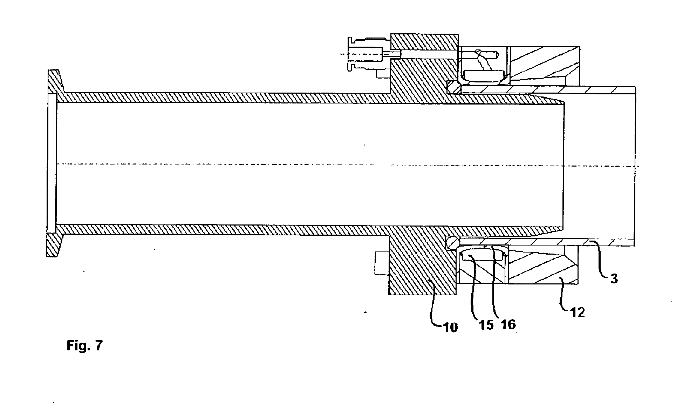

In den Figuren 5, 6 und 7 ist ein Aufnahmekörper 4 der Vorrichtung gemäß Figur 1 im Längsschnitt dargestellt. Der Aufnahmekörper weist ein rohrförmiges Ansatzstück 8, eine aufblasbare Dichtung 9, einen radial nach außen abstehenden Abschnitt 10, ein Pufferelement 11, einen Stützring 12 und ein Anschlussstück 13 auf. Über das rohrförmige Ansatzstück 8 wird das rohrförmige Bauteil 3 geschoben. Dies ist in Figur 6 und 7 erkennbar. Der Außendurchmesser des rohrförmigen Ansatzstücks 8 ist kleiner als der Innerdurchmesser des rohrförmigen Bauteils 3. Das rohrförmige Bauteil 3 stößt mit seiner Stirnseite an das Pufferelement 11, das in einer Vertiefung des radial nach außen abstehenden Abschnitts 10 angeordnet ist. Die aufblasbare Dichtung 9 ist zwischen dem radial nach außen abstehenden Abschnitt 10 und dem Stützring 12 gehalten. Sie weist einen Basiskörper 14, einen Hohlraum 15 und ein elastisches Element 16 auf. In den Hohlraum 15 wird über eine in dem Basiskörper 14 und dem radial nach außen abstehenden Abschnitt 10 verlaufende Leitung 17 Druckluft zugeführt und abgepumpt. Mit dem Anschlussstück 13 wird einer der Aufnahmekörper 4 an das System der Vakuumpumpen angeschlossen. Der andere Aufnahmekörper 4 wird mit dem Anschlussstück 13 an die Aufbereitungseinrichtung für den Beschichtungsstoff oder einen Precursor angeschlossen. Die Anschlussstücke sind auch in der Darstellung gemäß Figur 4 erkennbar.

Figur 7 zeigt den Aufnahmekörper 4 mit rohrförmigem Bauteil 3 und ausgedehnter aufblasbarer Dichtung 9. Von dem Bauteil 3 ist in der Darstellung nur das dem Aufnahmekörper 4 zugewandte Ende erkennbar. Figur 7 zeigt, dass der Hohlraum 15 aufgrund eines durch die Leitung 17 einströmenden Mediums aufgeweitet ist und das elastische Element gegen das rohrförmige Bauteil 3 gedrückt. Dabei wird der Übergang zwischen dem Aufnahmekörper 4 und dem Bauteil 3 abgedichtet. Aus der Zeichnung ist erkennbar, dass eine Abdichtung auch dann erfolgt, wenn zwischen dem rohrförmigen Ansatzstück 8 des Aufnahmekörpers 4 und dem Bauteil 3 ein Zwischenraum besteht.

Die in den Figuren 1 bis 7 dargestellte Vorrichtung eignet sich insbesondere zur Beschichtung von Glasrohren mit Siliziumdioxid für solarthermische Zwecke. Die Beschichtung reduziert die Reflexion des einfallenden Sonnenlichts und erhöht die optische Transmission. Zur Beschichtung wird ein siliziumhaltiger Alkohol in flüssiger Form verwendet, der nach seiner Aufbereitung dampfförmig vorliegt und unter Zugabe von Sauerstoff in das zu beschichtende Glasrohr geleitet wird. Im Plasma werden der siliziumhaltige Alkohol und der Sauerstoff zu Siliziumdioxid, Kohlendioxid und Wasser umgesetzt. Siliziumdioxid scheidet sich als Schicht an der Rohrinnenwand ab. Kohlendioxid, Wasser und überschüssiger Sauerstoff werden durch das System der Vakuumpumpen aus dem Glasrohr abgeführt.

Sämtliche Merkmale können sowohl einzeln als auch in beliebiger Kombination miteinander erfindungswesentlich sein.

### Bezugszahlen

- 1: Gehäuse
- 2: Klappe
- 3: rohrförmiges Bauteil
- 4: Aufnahmekörper
- 5: Stützeinrichtung
- 6: Spule
- 7: Gehäuseteil
- 8: rohrförmiges Ansatzstück
- 9: aufblasbare Dichtung
- 10: radial nach außen abstehender Abschnitt
- 11: Pufferelement
- 12: Stützring
- 13: Anschlussstück
- 14: Basiskörper
- 15: Hohlraum
- 16: Elastisches Element
- 17: Leitung

## Patentansprüche

1. Vorrichtung zur plasmagestützten Beschichtung der Innenseite von rohrförmigen Bauteilen mittels eines hochfrequenten Magnetfeldes mit mindestens zwei Aufnahmekörpern (4), welche ein rohrförmiges Bauteil (3) an dessen Enden aufnehmen, halten und das Innere des rohrförmigen Bauteils (3) gegen die Umgebung abdichten,
mit einer sich um die Außenseite und/ oder die Stirnseite eines rohrförmigen Bauteils (3) legenden aufblasbaren Dichtung (9) an dem Aufnahmekörper (4), welche im aufgeblasenen Zustand eine Abdichtung des Übergangs zwischen dem Aufnahmekörper (4) und dem rohrförmigen Bauteil (3) gegen die Umgebung ausbildet,
mit einem Hochfrequenzschwingkreis zur Erzeugung eines hochfrequenten Magnetfeldes,
mit einer Spule (6) des Hochfrequenzschwingkreises, deren Windungen koaxial zu einer Längsachse der Vorrichtung ausgerichtet ist, wobei die Längsachse durch eine Gerade vorgegeben ist, die durch beide Aufnahmekörper (4) verläuft,
mit einem Antrieb für die Spule (6) und/ oder die Aufnahmekörper (4), welcher die Spule (6) relativ zu den Aufnahmekörpern (4) oder die Aufnahmekörper (4) relativ zu der Spule (6) verschiebt.

2. Vorrichtung nach Anspruch 1, **dadurch gekennzeichnet, dass** die Aufnahmekörper (4) in entgegen gesetzte Richtungen verschiebbar angeordnet sind.

3. Vorrichtung nach Anspruch 1 oder 2, **dadurch gekennzeichnet, dass** sie zusätzlich zu den Aufnahmekörpern (4) mit Stützeinrichtungen (5) ausgestattet ist, welche eine Auflage für ein rohrförmiges Bauteil (3) von unten bilden.

4. Vorrichtung nach Anspruch 3, **dadurch gekennzeichnet, dass** die Stützeinrichtungen (5) ein U-förmiges Halteelement aufweisen.

5. Vorrichtung nach Anspruch 3 oder 4, **dadurch gekennzeichnet, dass** die Stützeinrichtungen (5) höhenverstellbar sind.

6. Vorrichtung nach einem der vorhergehenden Ansprüche, **dadurch gekennzeichnet, dass** die aufblasbare Dichtung (9) im ausgedehnten Zustand eine Ausdehnung in radialer Richtung bezogen auf die Längsachse der Aufnahmekörper (4) aufweist.

7. Vorrichtung nach einem der vorhergehenden Ansprüche, **dadurch gekennzeichnet, dass** die Aufnahmekörper (4) je ein rohrförmiges Ansatzstück (8) aufweisen, welches eine Auflage für die Innenseite des rohrförmigen Bauteils (3) an dessen Ende bildet.

8. Vorrichtung nach Anspruch 7, **dadurch gekennzeichnet, dass** das rohrförmige Ansatzstück (8) an seiner Innenseite einen zylindrischen Hohlraum begrenzt, und dass die Wandstärke des rohrförmigen Ansatzstücks (8) an dem dem anderen Aufnahmekörper (4) zugewandten Ende kleiner ist als an dem dem anderen Aufnahmekörper (4) abgewandten Ende.

9. Vorrichtung nach einem der vorhergehenden Ansprüche, **dadurch gekennzeichnet, dass** die Aufnahmekörper (4) mit einem radial nach außen abstehenden Abschnitt (10) ausgestattet sind, welcher einen Anschlag für die Stirnseite eines rohrförmigen Bauteils (3) bildet.

10. Vorrichtung nach Anspruch 9, **dadurch gekennzeichnet, dass** der radial nach außen abstehende Abschnitt (10) mit einer Vertiefung ausgestattet ist, und dass in der Vertiefung ein Pufferelement (11) aus einem elastischen Material angeordnet ist.

11. Vorrichtung nach Anspruch 9 oder 10, **dadurch gekennzeichnet, dass** der radial abstehenden Abschnitt (10) mit einem Anschluss für die Zufuhr und das Ableiten eines Mediums zum Aufblähen der aufblasbaren Dichtung ausgestattet ist.

12. Vorrichtung nach einem der vorhergehenden Ansprüche, **dadurch gekennzeichnet, dass** die aufblasbare Dichtung (9) durch einen Stützring (12) an dem Aufnahmekörper (4) gehalten ist.

13. Vorrichtung nach einem der vorhergehenden Ansprüche, **dadurch gekennzeichnet, dass** mindestens einer der Aufnahmekörper (4) mit einem Anschluss (13) an eine oder mehrere Pumpen ausgestattet ist.

14. Vorrichtung nach einem der vorhergehenden Ansprüche, **dadurch gekennzeichnet, dass** mindestens einer der Aufnahmekörper (4) mit einem Anschluss (13) für die Zufuhr eines Beschichtungsstoffs und/ oder eines Arbeitsgases in das Innere eines an den Aufnahmekörpern (4) angeordneten rohrförmigen Bauteils (3) ausgestattet ist.

15. Vorrichtung nach einem der vorhergehenden Ansprüche, **dadurch gekennzeichnet, dass** mindestens einer der Aufnahmekörper (4) mit einer ausfahrbaren Lanze für die Zufuhr eines Beschichtungsstoffs in das Innere eines an den Aufnahmekörpern (4) angeordneten rohrförmigen Bauteils (3) ausgestattet ist.

## Claims

1. Device for the plasma-assisted coating of the inner side of tubular components by means of a high-frequency magnetic field,
with at least two receiving bodies (4) which accommodate a tubular component (3) on the ends thereof, maintain said component and seal the inside of the tubular component (3) in relation to the surroundings,
with an inflatable seal (9) on the receiving body (4) that is arranged about the outer side and/or the front side of a tubular component (3) with said seal forming, when inflated, a seal of the transition between the receiving body (4) and the tubular component (3) in relation to the surroundings,
with a high-frequency oscillating circuit for producing a high-frequency magnetic field,
with a coil (6) of the high-frequency oscillating circuit, the windings thereof being aligned coaxially to a longitudinal axis of said device, whereby the longitudinal axis is predefined by a straight line that extends through both receiving bodies (4),
with a drive for the coil (6) and/or the receiving bodies (4) that displaces the coil (6) relative to the receiving bodies (4) or the receiving bodies (4) relative to the coil (6).

2. Device according to claim 1, **characterised in that** the receiving bodies (4) are arranged to be displaceable in opposing directions.

3. Device according to claim 1 or 2, **characterised in that** in addition to the receiving bodies (4) it is also equipped with support fixtures (5) which form a rest for a tubular component (3) from the underneath.

4. Device according to claim 3, **characterised in that** the support fixtures (5) comprise a U-shaped retaining element.

5. Device according to claim 3 or 4, **characterised in that** the support fixtures (5) are adjustable in height.

6. Device according to one of the previous claims, **characterised in that**, when expanded, the inflatable seal (9) expands in the radial direction relative to the longitudinal axis of the receiving bodies (4).

7. Device according to one of the previous claims, **characterised in that** the receiving bodies (4) each have a tubular extension (8) which forms a support for the inner side of the tubular component (3) at the end of it.

8. Device according to claim 7, **characterised in that** the tubular extension (8) defines on its inner side a cylindrical cavity and that the wall thickness of the tubular extension (8) is smaller at the end facing the other receiving body (4) than at the end facing away from the other receiving body (4).

9. Device according to one of the previous claims, **characterised in that** the receiving bodies (4) are equipped with a portion (10) protruding radially outwards and forming a stop for the front side of a tubular component (3).

10. Device according to claim 9, **characterised in that** the portion (10) protruding radially outwards is equipped with an indentation and that a buffer element (11) made of an elastic material is arranged in the indentation.

11. Device according to claim 9 or 10, **characterised in that** the radially protruding portion (10) is equipped with a connection for the delivery and removal of a medium for inflating the inflatable seal.

12. Device according to one of the previous claims, **characterised in that** the inflatable seal (9) is held on the receiving body (4) by a support ring (12).

13. Device according to one of the previous claims, **characterised in that** at least one of the receiving bodies (4) is equipped with a connection (13) to one or more pumps.

14. Device according to one of the previous claims, **characterised in that** at least one of the receiving bodies (4) is equipped with a connection (13) for the delivery of a coating material and/or a working gas into the interior of a tubular component (3) arranged on the receiving bodies (4).

15. Device according to one of the previous claims, **characterised in that** at least one of the receiving bodies (4) is equipped with an extendable lance for the delivery of a coating material into the interior of a tubular component (3) arranged on the receiving bodies (4).

## Revendications

1. Dispositif pour une application de revêtement assistée par plasma sur le côté intérieur de pièces tubulaires au moyen d'un champ magnétique à haute fréquence
avec au moins deux corps récepteurs (4) qui reçoivent une pièce tubulaire (3) au niveau de ses extrémités, la maintiennent en place et colmatent la pièce tubulaire (3) pour protéger l'intérieur des influences extérieures, avec, au niveau du corps récepteur (4), un joint gonflable (9) se plaçant autour de la face extérieure et/ou de la face frontale d'une pièce tubulaire (3) et qui, à l'état gonflé, colmate le passage entre le corps récepteur (4) et la pièce tubulaire (3) pour le rendre étanche aux influences extérieures,
avec un circuit oscillant à haute fréquence pour la génération d'un champ magnétique à haute fréquence,
avec une bobine (6) du circuit oscillant à haute fréquence dont les spires sont orientées de manière coaxiale par rapport à un axe longitudinal du dispositif, l'axe longitudinal étant défini par une droite qui passe par les deux corps récepteurs (4),
avec un entraînement pour la bobine (6) et/ou les corps récepteurs (4), lequel déplace la bobine (6) par rapport aux corps récepteurs (4) ou les corps récepteurs (4) par rapport à la bobine (6).

2. Dispositif selon la revendication 1, **caractérisé en ce que** les corps récepteurs (4) sont disposés pour pouvoir être déplacés dans les directions opposées.

3. Dispositif selon la revendication 1 ou 2, **caractérisé en ce qu'**il est doté, en plus des corps récepteurs (4), de dispositifs d'appui (5) qui soutiennent une pièce tubulaire (3) par le bas.

4. Dispositif selon la revendication 3, **caractérisé en ce que** les dispositifs d'appui (5) présentent un élément de fixation en forme de U.

5. Dispositif selon la revendication 3 ou 4, **caractérisé en ce que** les dispositifs d'appui (5) sont réglables en hauteur.

6. Dispositif selon l'une quelconque des revendications précédentes, **caractérisé en ce que** le joint gonflable (9), à l'état dilaté, présente une dilatation dans le sens radial par rapport à l'axe longitudinal des corps récepteurs (4).

7. Dispositif selon l'une quelconque des revendications précédentes, **caractérisé en ce que** chaque corps récepteur (4) présente un embout tubulaire (8) qui constitue un support pour l'intérieur de la pièce tubulaire (3) à son extrémité.

8. Dispositif selon la revendication 7, **caractérisé en ce que** l'embout tubulaire (8) au niveau de sa face intérieure limite une cavité cylindrique, et **en ce que** l'épaisseur de l'embout tubulaire (8) au niveau de l'extrémité du côté de l'autre corps récepteur (4) est inférieure à celle au niveau de l'extrémité opposée à l'autre corps récepteur (4).

9. Dispositif selon l'une quelconque des revendications précédentes, **caractérisé en ce que** les corps récepteurs (4) sont dotés d'une partie (10) en saillie vers l'extérieur de manière radiale qui forme une butée pour la face frontale d'une pièce tubulaire (3).

10. Dispositif selon la revendication 9, **caractérisé en ce que** la partie (10) en saillie vers l'extérieur de manière radiale est dotée d'un creux, et **en ce qu'**un élément tampon (11) fait d'un matériau élastique est logé dans le creux.

11. Dispositif selon la revendication 9 ou 10, **caractérisé en ce que** la partie (10) en saillie de manière radiale est dotée d'un raccord pour l'apport et l'évacuation d'un fluide destiné à gonfler le joint gonflable.

12. Dispositif selon l'une quelconque des revendications précédentes, **caractérisé en ce que** le joint gonflable (9) est maintenu au niveau du corps récepteur (4) par une bague d'appui (12).

13. Dispositif selon l'une quelconque des revendications précédentes, **caractérisé en ce qu'**au moins un des corps récepteurs (4) est doté d'un raccord (13) vers une ou plusieurs pompes.

14. Dispositif selon l'une quelconque des revendications précédentes, **caractérisé en ce qu'**au moins un des corps récepteurs (4) est doté d'un raccord (13) pour l'apport d'une substance de revêtement et/ou d'un gaz de travail à l'intérieur d'une pièce tubulaire (3) logée au niveau des corps récepteurs (4).

15. Dispositif selon l'une quelconque des revendications précédentes, **caractérisé en ce qu'**au moins un des corps récepteurs (4) est doté d'une lance extractible pour l'apport d'une substance de revêtement à l'intérieur d'une pièce tubulaire (3) logée au niveau des corps récepteurs (4).
